# EUROPEAN PATENT APPLICATION

(11) **EP 4 135 033 A1**
(43) Date of publication of application: **15.02.2023**
(21) Application number: 21785344.9
(22) Date of filing: 29.03.2021
(51) Int. Cl.: H01L 27/04, G01R 31/28, G01R 31/3185, H03K 17/00, H03K 17/22

(54) **INTEGRATED CIRCUIT**

(30) Priority: 09.04.2020 JP 2020070469
(71) Applicant: Minebea Mitsumi Inc., Kitasaku-gun, Nagano 3890293 (JP)
(72) Inventor: MOGI, Akira, Tama-shi, Tokyo 206-8567 (JP); OTSUKA, Shinya, Tama-shi, Tokyo 206-8567 (JP)
(74) Representative: Regimbeau
(86) International application number: PCT/JP2021/013280
(87) International publication number: WO 2021/205924

(57) **Abstract**

An integrated circuit includes: a power supply terminal configured to receive a power supply voltage as input; a power supply voltage detection part configured to output a power supply voltage detection signal in accordance with the state of the power supply voltage as input to the power supply terminal; an operation mode signal input terminal configured to receive an operation mode signal as input; and an operation mode determining part configured to determine an operation mode based on the operation mode signal and the power supply voltage detection signal.

## Description

### TECHNICAL FIELD

The present invention relates to an integrated circuit.

### BACKGROUND ART

Patent Document 1 below discloses a technique for outputting one of a signal that is output from a boundary scan register and a signal that is output from a scan flip-flop circuit, from a multiplexer, depending on the value of a mode signal that is input to the multiplexer, in an output buffer provided in a semiconductor integrated circuit.

### RELATED-ART DOCUMENT

### PATENT DOCUMENT

Patent Document 1: Unexamined Japanese Patent Application Publication No. 2004-260093

### SUMMARY OF THE INVENTION

### PROBLEM TO BE SOLVED BY THE INVENTION

However, according to the technique of Patent Document 1, there is only one mode-signal input terminal, so that it is only possible to switch between two operation modes. Consequently, with the above conventional technique, in order to switch more operation modes from the outside, it is then necessary to increase the number of input terminals for operation-mode switching. For example, given a conventional integrated circuit, in order to switch between 16 operation modes from the outside, it is necessary to provide at least four input terminals for operation-mode switching.

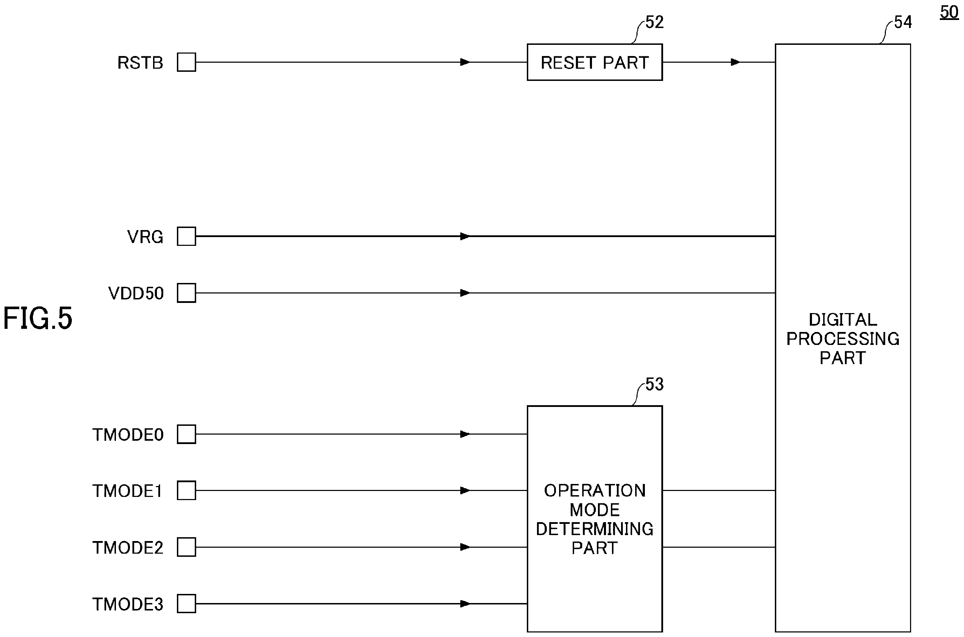

For example, FIG. 5 is a diagram showing a configuration of a conventional integrated circuit 50. The conventional integrated circuit 50 shown in FIG. 5 is, for example, an integrated circuit that performs predetermined processes (for example, amplification, AD conversion, etc.) on a sensor signal output from a sensor. The integrated circuit 50 has multiple modes of operation. These multiple operation modes include operation modes for testing the integrated circuit 50. The operation mode, in which the integrated circuit 50 operates, can be switched from the outside.

As shown in FIG. 5, the integrated circuit 50 includes a first power supply terminal VDD 50, a second power supply terminal VRG, four operation mode signal input terminals TMODE 0 to TMODE 3, a reset signal input terminal RSTB, a reset part 52, an operation mode determining part 53, and a digital processing part 54.

A first power supply voltage (for example, 5.0 V) for operating the integrated circuit 50 is input to the first power supply terminal VDD 50. A second power supply voltage (for example, 1.8 V) for operating the integrated circuit 50 is input to the second power supply terminal VRG. An operation mode signal is input to each of the four operation mode signal input terminals TMODE 0 to TMODE 3. Each operation mode signal is set to "0" or "1." An external reset signal RSTB is input to the reset signal input terminal RSTB. When an external reset signal RSTB is input via the reset signal input terminal RSTB, the reset part 52 restarts the digital processing part 54.

Based on the four operation mode signals input from the four operation mode signal input terminals TMODE 0 to TMODE 3, the operation mode determining part 53 determines the operation mode to apply to the operation of the integrated circuit 50. The operation mode determining part 53 then reports the determined operation mode to the digital processing part 54. As a result of this, the operation mode determining part 53 can switch between the 16 operation modes of the digital processing part 54 by using four operation mode signals. For this reason, the integrated circuit 50 is provided with four operation mode signal input terminals TMODE 0 to TMODE 3 for operation-mode switching.

### MEANS FOR SOLVING THE PROBLEM

According to one embodiment of the present disclosure, an integrated circuit includes: a power supply terminal configured to receive a power supply voltage as input; a power supply voltage detection part configured to output a power supply voltage detection signal in accordance with the state of the power supply voltage as input to the power supply terminal; an operation mode signal input terminal configured to receive an operation mode signal as input; and an operation mode determining part configured to determine an operation mode based on the operation mode signal and the power supply voltage detection signal.

### EFFECTS OF THE INVENTION

According to the above integrated circuit of one embodiment, more operation modes can be switched from the outside without increasing the number of input terminals for operation-mode switching.

### BRIEF DESCRIPTION OF THE DRAWINGS

FIG. 1 is a diagram showing a configuration of an integrated circuit according to one embodiment;
FIG. 2 is a diagram showing an example of a decision table included in the integrated circuit according to one embodiment;
FIG. 3 is a diagram showing examples of operation timings of the integrated circuit according to one embodiment;
FIG. 4 is a diagram showing other examples of operation timings of the integrated circuit according to one embodiment; and
FIG. 5 is a diagram showing a configuration of a conventional integrated circuit.

### MODE OF CARRYING OUT THE INVENTION

An embodiment will be described below with reference to the accompanying drawings.

### (Configuration of integrated circuit 10)

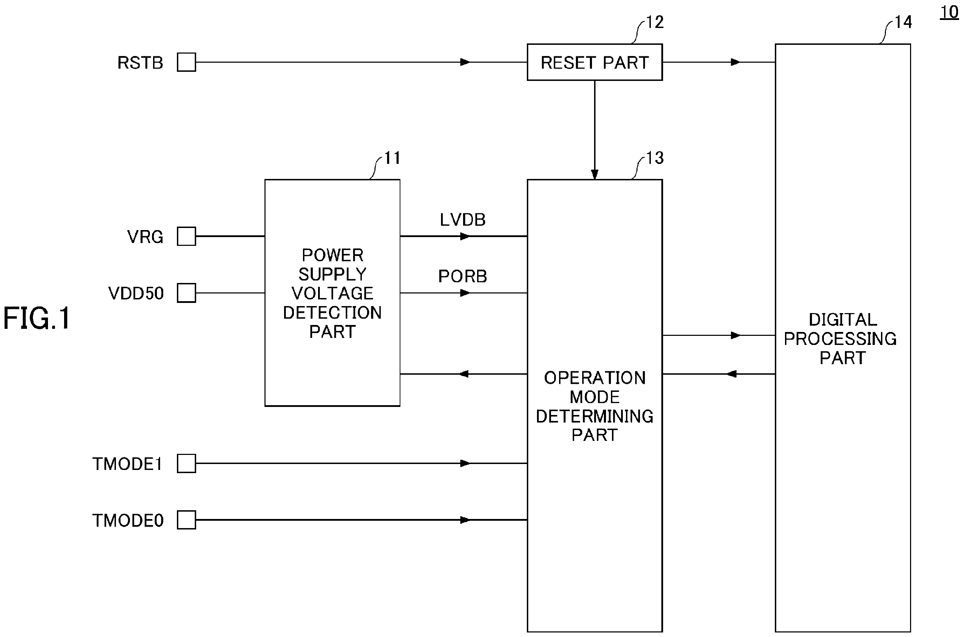

FIG. 1 is a diagram showing a configuration of an integrated circuit 10 according to one embodiment. The integrated circuit 10 shown in FIG. 1 is, for example, an integrated circuit that performs predetermined processes (for example, amplification, AD conversion, etc.) on a sensor signal that is output from a sensor. The integrated circuit 10 has multiple modes of operation. These multiple operation modes include operation modes for testing the integrated circuit 10. The operation mode, in which the integrated circuit 10 operates, can be switched from the outside.

As shown in FIG. 1, the integrated circuit 10 includes a first power supply terminal VDD 50, a second power supply terminal VRG, a first operation mode signal input terminal TMODE 1, a second operation mode signal input terminal TMODE 0, a reset signal input terminal RSTB, a power supply voltage detection part 11, a reset part 12, an operation mode determining part 13, and a digital processing part 14.

A first power supply voltage (for example, 5.0 V) for operating the integrated circuit 10 is input to the first power supply terminal VDD 50. A second power supply voltage (for example, 1.8 V) for operating the integrated circuit 10 is input to the second power supply terminal VRG. A first operation mode signal is input to the first operation mode signal input terminal TMODE 1. A second operation mode signal is input to the second operation mode signal input terminal TMODE 0. The first operation mode signal and the second operation mode signal are set to "0" or "1." An external reset signal RSTB is input to the reset signal input terminal RSTB.

The power supply voltage detection part 11 detects the first power supply voltage (5.0 V) as input to the first power supply terminal VDD 50, and outputs a first voltage detection signal LVDB, according to the state of the first power supply voltage (5.0 V) as input. To be more specific, the power supply voltage detection part 11 outputs a first power supply voltage detection signal LVDB that becomes "0 (OFF)" when the first power supply voltage (5.0 V) is not input, and becomes "1 (ON)" when the first power supply voltage (5.0 V) is input.

Also, the power supply voltage detection part 11 detects the second power supply voltage (1.8 V) as input to the second power supply terminal VRG, and outputs a power supply voltage detection signal PORB in accordance with the state of the second power supply voltage (1.8 V) as input. To be more specific, the power supply voltage detection part 11 outputs a second power supply voltage detection signal PORB that becomes "0 (OFF) " when the second power supply voltage (1.8 V) is not input, and becomes "1 (ON)" when the second power supply voltage (1.8 V) is input.

To be more specific, when the voltage input to the first power supply terminal VDD 50 is compared with a reference voltage by using a comparator and the input voltage reaches a predetermined voltage, the "power supply voltage detection part" outputs the first power supply voltage detection signal LVDB that is "1 (ON)." Also, when the voltage input to the second power supply terminal VRG is compared with a reference voltage by using a comparator and the input voltage reaches a predetermined voltage, the "power supply voltage detection part" outputs the second power supply voltage detection signal PORB that is "1 (ON)." However, as long as the "power supply voltage detection part" can output the first power supply detection signal LVDB and the power supply voltage detection signal PORB of "1" when the first power supply voltage (5.0 V) and the second power supply voltage (1.8 V) are input, the "power supply voltage detection part" may have any configuration and may be configured as, for example, a comparator, an inverter, an amplifier, and the like.

The reset part 12 restarts the digital processing part 14 when the external reset signal RSTB is input via the reset signal input terminal RSTB.

The operation mode determining part 13 determines the operation mode to apply to the operation of the integrated circuit 10 based on the first power supply voltage detection signal LVDB, the second power supply voltage detection signal PORB, the first operation mode signal, and the second operation mode signal. The operation mode determining part 13 then reports the determined operation mode to the digital processing part 14.

To be more specific, the operation mode determining part 13 determines the operation mode that corresponds to the combination of: the value of the first operation mode signal and the value of the second operation mode signal as of when the first power supply voltage detection signal LVDB is switched from "OFF" to "ON"; and the value of the first operation mode signal and the value of the second operation mode signal as of when the second power supply voltage detection signal PORB is switched from "OFF" to "ON," as the operation mode to apply to the operation of the integrated circuit 10.

### (Example of decision table)

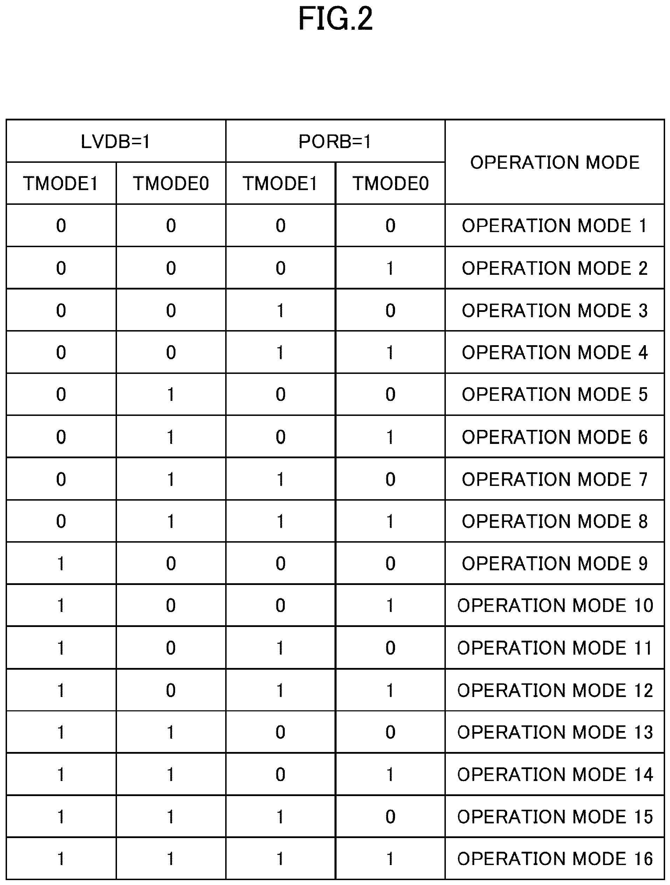

FIG. 2 is a diagram showing an example of a decision table included in the integrated circuit 10 according to one embodiment. As shown in FIG. 2, the integrated circuit 10 according to one embodiment supports 16 operation modes (operation mode 1 to operation mode 16). The 16 operation modes are, for example, four operation modes, namely a normal operation mode, a test mode 1, a test mode 2, and a test mode 4, where each operation mode is available in four combinations of an operation setting 1 and an operation setting 2. The test modes include, for example, a burn-in test mode, a test mode that does not load the NVMs related to the reliability test, a test mode that does not load all the NVMs, a scan test mode, and so forth. Also, the operation settings include, for example, whether or not an input filter for I2C (Inter-Integrated Circuit) is provided, whether or not the threshold is changed, and so forth.

In the decision table shown in FIG. 2, each of the 16 operation modes the integrated circuit 10 supports is associated with a combination of four signal values that are input to the integrated circuit 10, serving as a determination condition for determining the operation mode.

The four signal values input to the integrated circuit 10 refer to: the value of the first operation mode signal and the value of the second operation mode signal as of when the first power supply voltage detection signal LVDB is switched from "0" to "1"; and the value of the first operation mode signal and the value of the second operation mode signal as of when the second power supply voltage detection signal PORB is switched from "0" to "1."

Note that, in the decision table shown in FIG. 2, "LVDB = 1" indicates when the first power supply voltage detection signal LVDB is switched from "0" to "1."

Also, in the decision table shown in FIG. 2, "PORB = 1" indicates when the second power supply voltage detection signal PORB is switched from "0" to "1."

Also, in the decision table shown in FIG. 2, "TMODE 1" means the value of the first operation mode signal that is input from the first operation mode signal input terminal TMODE 1.

Also, in the decision table shown in FIG. 2, "TMODE 0" means the value of the second operation mode signal that is input from the second operation mode signal input terminal TMODE 0.

Based on the decision table shown in FIG. 2, the operation mode determining part 13 selects the operation mode that corresponds to the combination of four signal values input to the integrated circuit 10, from the 16 operation modes for the integrated circuit 10, as the operation mode to apply to the operation of the integrated circuit.

For example, when the value of the first operation mode signal and the value of the second operation mode signal as of when the first power supply voltage detection signal LVDB is switched from "0" to "1"; and the value of the first operation mode signal and the value of the second operation mode signal as of when the second power supply voltage detection signal PORB is switched from "0" to "1" are all "0," the operation mode determining part 13 determines "operation mode 1" as the operation mode to apply to the operation of the integrated circuit 10, based on the decision table shown in FIG. 2.

### (Example of Operation Timing of Integrated Circuit 10)

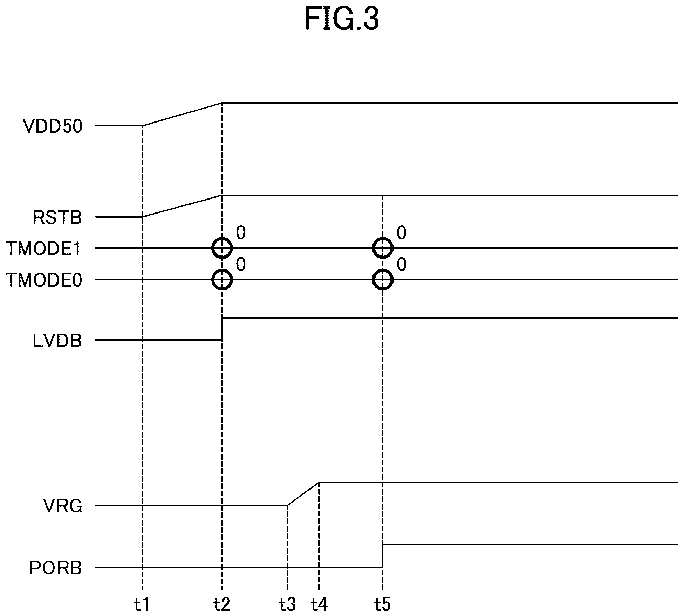

FIG. 3 is a diagram showing examples of operation timings of the integrated circuit 10 according to one embodiment.

As shown in FIG. 3, when a voltage starts being applied to the first power supply terminal VDD 50 (timing t1) and subsequently the voltage value at the first power supply terminal VDD 50 reaches a predetermined voltage, the power supply voltage detection part 11 switches the first power supply voltage detection signal LVDB from "0" to "1" (timing t2) .

At this timing, the operation mode determining part 13 latches the value of the first operation mode signal that is input from the first operation mode signal input terminal TMODE 1, and the value of the second operation mode signal that is input from the second operation mode signal input terminal TMODE 0.

Following this, when a voltage starts being applied to the second power supply terminal VRG (timing t3) and subsequently the voltage value at the second power supply terminal VRG reaches a predetermined voltage (timing t4), the power supply voltage detection part 11 switches the second power supply voltage detection signal PORB from "0" to "1" (timing t5).

At this timing, the operation mode determining part 13 latches the value of the first operation mode signal that is input from the first operation mode signal input terminal TMODE 1 and the value of the second operation mode signal that is input from the second operation mode signal input terminal TMODE 0.

Then, based on the decision table shown in FIG. 2, the operation mode determining part 13 determines the operation mode that corresponds to the combination of: the value of the first operation mode signal and the value of the second operation mode signal latched at timing t2; and the value of the first operation mode signal and the value of the second operation mode signal latched at timing t5, as the operation mode to apply to the operation of the integrated circuit 10.

For example, in the example shown in FIG. 3, the value of the first operation mode signal and the value of the second operation mode signal latched at timing t2; and the value of the first operation mode signal and the value of the second operation mode signal latched at timing t5, are all "0." In this case, the operation mode determining part 13 determines "operation mode 1" as the operation mode to apply to the operation of the integrated circuit 10, based on the decision table shown in FIG. 2.

Furthermore, the operation mode determining part 13 reports the determined operation mode to the digital processing part 14. As a result of this, the integrated circuit 10 operates in the operation mode determined by the operation mode determining part 13.

### (Another example of operation timing of the integrated circuit 10)

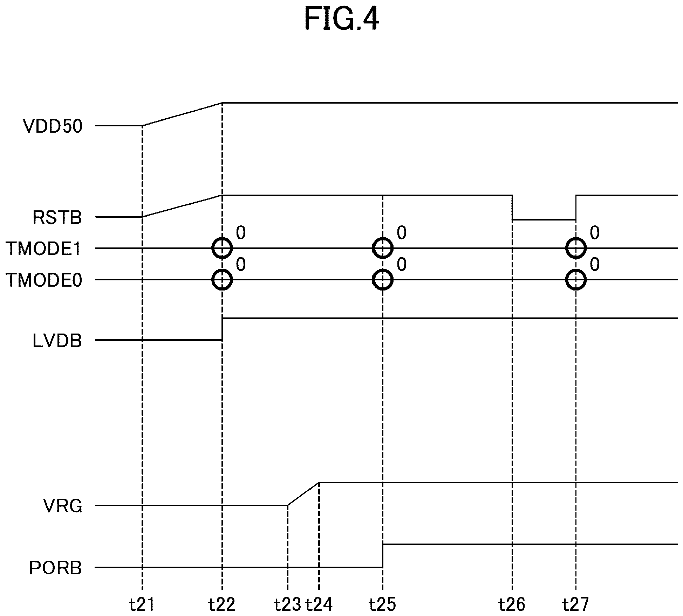

FIG. 4 is a diagram showing other examples of operation timings of the integrated circuit 10 according to one embodiment.

As shown in FIG. 4, when a voltage starts being applied to the first power supply terminal VDD 50 (timing t21) and subsequently the voltage value at the first power supply terminal VDD 50 reaches a predetermined voltage, the power supply voltage detection part 11 switches the first power supply voltage detection signal LVDB from "0" to "1" (timing t22).

At this timing, the operation mode determining part 13 latches the value of the first operation mode signal that is input from the first operation mode signal input terminal TMODE 1, and the value of the second operation mode signal that is input from the second operation mode signal input terminal TMODE 0.

Following this, when a voltage starts being applied to the second power supply terminal VRG (timing t23) and subsequently the voltage value at the second power supply terminal VRG reaches a predetermined voltage (timing t24), the power supply voltage detection part 11 switches the second power supply voltage detection signal PORB from "0" to "1" (timing t25).

Subsequently, when the external reset signal RSTB that is input from the reset signal input terminal RSTB switches from "1" to "0" (timing t26), and, furthermore, the external reset signal RSTB switches from "0" to "1" (timing t27), at this timing, the operation mode determining part 13 latches the value of the first operation mode signal that is input from the first operation mode signal input terminal TMODE 1 and the value of the second operation mode signal that is input from the second operation mode signal input terminal TMODE 0.

Then, based on the decision table shown in FIG. 2, the operation mode determining part 13 determines the operation mode that corresponds to the combination of: the value of the first operation mode signal and the value of the second operation mode signal latched at timing t22; and the value of the first operation mode signal and the value of the second operation mode signal latched at timing t25, as the operation mode to apply to the operation of the integrated circuit 10.

For example, in the example shown in FIG. 4, the value of the first operation mode signal and the value of the second operation mode signal latched at timing t22; and the value of the first operation mode signal and the value of the second operation mode signal latched at timing t27, are all "0." In this case, the operation mode determining part 13 determines "operation mode 1" as the operation mode to apply to the operation of the integrated circuit 10, based on the decision table shown in FIG. 2.

Furthermore, the operation mode determining part 13 reports the determined operation mode to the digital processing part 14. As a result of this, the integrated circuit 10 operates in the operation mode determined by the operation mode determining part 13.

As described above, the integrated circuit 10 according to one embodiment includes a power supply terminal that receives a power supply voltage as input, a power supply voltage detection part 11 that outputs a power supply voltage detection signal in accordance with the state of the power supply voltage as input to the power supply terminal, an operation mode signal input terminal that receives an operation mode signal as input, and an operation mode determining part 13 that determines the operation mode based on the operation mode signal and the power supply voltage detection signal.

By this means, the integrated circuit 10 according to one embodiment can switch, from the outside, between operation modes that match in number the combinations of the value of the operation mode signal and the value of the power supply voltage detection signal. A power supply terminal is provided in all integrated circuits, and therefore can be used without increasing the number of input terminals. Therefore, according to the integrated circuit 10 of one embodiment, more operation modes can be switched from the outside without increasing the number of input terminals for operation-mode switching.

Also, the integrated circuit 10 according to one embodiment includes: a first power supply terminal VDD 50 that receives a first power supply voltage (5.0 V) as input; a second power supply terminal VRG that receives a second power supply voltage (1.8 V) as input; a first operation mode signal input terminal TMODE 1 that receives a first operation mode signal as input; and a second operation mode signal input terminal TMODE 0 that receives a second operation mode signal as input. The power supply voltage detection part 11 outputs a first power supply voltage detection signal LVDB in accordance with the state of the first power supply voltage (5.0 V) as input, and outputs a second power supply voltage detection signal PORB in accordance with the state of the second power supply voltage (1.8 V) as input. The operation mode determining part 13 determines the operation mode based on the first power supply voltage detection signal LVDB, the second power supply voltage detection signal PORB, the first operation mode signal, and the second operation mode signal.

By this means, the integrated circuit 10 according to one embodiment can switch, from the outside, between operation modes that match in number the combinations (that is, 16 combinations) of the first power supply voltage detection signal LVDB, the second power supply voltage detection signal PORB, the first operation mode signal, and the second operation mode signal. Therefore, according to the integrated circuit 10 of one embodiment, more operation modes can be switched from the outside, without increasing the number of input terminals for operation-mode switching.

Also, in the integrated circuit 10 according to one embodiment, the operation mode determining part 13 determines the operation mode that corresponds to the combination of: the value of the first operation mode signal and the value of the second operation mode signal as of when the first power supply voltage detection signal LVDB is switched from "OFF" to "ON"; and the value of the first operation mode signal and the value of the second operation mode signal as of when the second power supply voltage detection signal PORB is switched from "OFF" to "ON," as the operation mode.

By this means, the integrated circuit 10 according to one embodiment can utilize the timing at which the first power supply voltage (5.0 V) is input and the timing at which the second power supply voltage (1.8 V) is input, to allow the value of the first operation mode signal and the value of the second operation mode signal to have different meanings. That is, the integrated circuit 10 according to one embodiment acquires the value of the first operation mode signal and the value of the second operation mode signal at two respective timings, so that the integrated circuit 10 can double the number of combinations of the value of the first operation mode signal and the value of the second operation mode signal (the number of operation modes subject to switching) without increasing the number of input terminals for operation-mode switching.

Note that the integrated circuit 10 according to one embodiment is applicable to, for example, an AFE (Analog Front End) for connecting between a plurality of sensors (for example, a plurality of strain sensors for detecting the load applied to an object) and an MCU (Micro Control Unit). In this case, the integrated circuit 10 functions as the AFE, and is composed of a multiplexer that selects any one of a plurality of sensor signals output from a plurality of sensors, an amplifier that amplifies the sensor signal selected by the multiplexer; an AD converter that converts the sensor signal amplified by the amplifier from an analog signal to a digital signal; a digital processing circuit (equivalent to the digital processing part 14) that performs predetermined digital processing (including, for example, digital filtering, data transmission to the MCU via I2C communication, etc.) on the sensor signal (digital signal) output from the AD converter.

Although one embodiment of the present invention has been described in detail above, the present invention is not limited to this embodiment, and a variety of alterations and changes can be made within the scope of the claims recited herein.

For example, in the integrated circuit 10 according to one embodiment, the operation mode determining part 13 may determine the operation mode corresponding to a combination of: the value of the first operation mode signal and the value of the second operation mode signal as of when the first power supply voltage detection signal LVDB is switched from "OFF" to "ON"; the value of the first operation mode signal and the value of the second operation mode signal as of when the second power supply voltage detection signal PORB is switched from "OFF" to "ON"; and the order in which the first power supply voltage detection signal LVDB and the second power supply voltage detection signal PORB are switched from "OFF" to "ON," as the operation mode.

By this means, the integrated circuit 10 according to one embodiment can switch, from the outside, between operation modes that match in number the combinations (that is, 32 combinations) of the first power supply voltage detection signal LVDB, the second power supply voltage detection signal PORB, the first operation mode signal, the second operation mode signal, and the order in which the first power supply voltage detection signal LVDB and the second power supply voltage detection signal PORB are switched from "OFF" to "ON."

Also, although, for example, in one embodiment, two input terminals are provided on an integrated circuit for receiving operation mode signals as input, this is by no means a limitation, and, in the event the integrated circuit is provided with three or more input terminals for receiving operation mode signals as input, it then becomes possible to switch between a larger number of operation modes, from the outside, by using these three or more input terminals for operation-mode switching.

For example, although, in one embodiment, two power supply terminals are provided on the integrated circuit, this is by no means a limitation, and, in the event the integrated circuit is provided with three or more power supply terminals, it then becomes possible to switch between a larger number of operation modes, from the outside, by using these three or more input terminals for operation-mode switching.

Also, although an example has been described with one embodiment where an external reset terminal is used, in addition to power supply terminals, for operation-mode switching, this is by no means a limitation, and for example, an external reset terminal may be used instead of power supply terminals for operation-mode switching. In this case, again, it is possible to switch between a larger number of operation modes from the outside, without increasing the number of terminals for operation-mode switching.

This international application is based on and claims priority to Japanese Patent Application No. 2020-070469, filed on April 9, 2020, the entire contents of which are incorporated herein by reference.

### DESCRIPTION OF THE REFERENCE NUMERALS

- 10: integrated circuit
- 12: reset part
- 11: power supply voltage detection part
- 13: operation mode determining part
- 14: digital processing part
- RSTB: reset signal input terminal
- TMODE 1: first operation mode signal input terminal
- TMODE 0: second operation mode signal input terminal
- VDD 50: first power supply terminal
- VRG: second power supply terminal

## Claims

1. An integrated circuit comprising:
a power supply terminal configured to receive a power supply voltage as input;
a power supply voltage detection part configured to output a power supply voltage detection signal in accordance with a state of the power supply voltage as input to the power supply terminal;
an operation mode signal input terminal configured to receive an operation mode signal as input; and
an operation mode determining part configured to determine an operation mode based on the operation mode signal and the power supply voltage detection signal.

2. The integrated circuit according to claim 1, further comprising:
a first power supply terminal configured to receive a first power supply voltage as input;
a second power supply terminal configured to receive a second power supply voltage as input;
a first operation mode signal input terminal configured to receive a first operation mode signal as input; and
a second operation mode signal input terminal configured to receive a second operation mode signal as input,
wherein the power supply voltage detection part outputs a first power supply voltage detection signal in accordance with a state of the first power supply voltage as input and outputs a second power supply voltage detection signal in accordance with a state of the second power supply voltage as input, and
wherein the operation mode determining part determines the operation mode based on the first power supply voltage detection signal, the second power supply voltage detection signal, the first operation mode signal, and the second operation mode signal.

3. The integrated circuit according to claim 2, wherein the operation mode determining part determines an operation mode that corresponds to a combination of: a value of the first operation mode signal and a value of the second operation mode signal as of when the first power supply voltage detection signal is switched from "OFF" to "ON"; and the value of the first operation mode signal and the value of the second operation mode signal as of when the second power supply voltage detection signal is switched from "OFF" to "ON," as the operation mode.

4. The integrated circuit according to claim 3, wherein the operation mode determining part latches the value of the first operation mode signal and the value of the second operation mode signal when the first power supply voltage detection signal is switched from "OFF" to "ON," latches the value of the first operation mode signal and the value of the second operation mode signal when the second power supply voltage detection signal is switched from "OFF" to "ON," and determines an operation mode that corresponds to a combination of the four latched values as the operation mode.

5. The integrated circuit according to claim 2, wherein the operation mode determining part determines an operation mode that corresponds to a combination of: the value of the first operation mode signal and the value of the second operation mode signal as of when the first power supply voltage detection signal is switched from "OFF" to "ON"; the value of the first operation mode signal and the value of the second operation mode signal as of when the second power supply voltage detection signal is switched from "OFF" to "ON"; and an order in which the first power supply voltage detection signal and the second power supply voltage detection signal are switched from "OFF" to "ON," as the operation mode.

6. The integrated circuit according to claim 2, wherein the operation mode determining part determines an operation mode that corresponds to a combination of: the value of the first operation mode signal and the value of the second operation mode signal as of when the first power supply voltage detection signal is switched from "OFF" to "ON"; and the value of the first operation mode signal and the value of the second operation mode signal as of when an external reset signal is switched after the second power supply voltage detection signal is switched from "OFF" to "ON," as the operation mode.

7. An integrated circuit comprising:
a reset signal input terminal configured to receive an external reset signal as input;
an operation mode signal input terminal configured to receive an operation mode signal as input; and
an operation mode determining part configured to determine an operation mode based on the operation mode signal and the external reset signal.
